(19)

Europäisches
Patentamt
European
Patent Office
Office européen
des brevets

(11)  **EP 2 908 430 A1**

(12)  # EUROPEAN PATENT APPLICATION

(43) Date of publication:
**19.08.2015  Bulletin 2015/34**

(21) Application number: **15153651.3**

(22) Date of filing: **03.02.2015**

(51) Int Cl.:
*H02S 10/30* (2014.01)   *G02B 5/00* (2006.01)
*B82Y 40/00* (2011.01)   *G02B 5/18* (2006.01)
*B82Y 20/00* (2011.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **13.02.2014  US 201414180333**

(71) Applicant: **Palo Alto Research Center
Incorporated
Palo Alto, California 94304 (US)**

(72) Inventor: **Casse, Bernard D.
Saratoga, CA California 95070 (US)**

(74) Representative: **Walls, Steven Brodie
Gill Jennings & Every LLP
The Broadgate Tower
20 Primrose Street
London EC2A 2ES (GB)**

(54)   **Spectrally-selective metamaterial emitter**

(57)    A spectrally-selective metamaterial emitter includes circular target-shaped bull's eye structures (120) disposed on a base substrate and including concentric circular ridges separated by circular grooves and set at a fixed grating period (e.g., in the range of 10 nanometers to 5 micrometers). When the base substrate is heated to a high temperature (i.e., above 1000°K), thermally excited surface plasmons generated on the concentric circular ridges produce a highly directional, narrow band energy beam having a peak emission wavelength that is roughly equal to the fixed grating period. The metamaterial emitter is fabricated using known photolithographic (e.g., combination of primary pattern generation and sputtering or dry etching) fabrication techniques, and utilizes an all-metal structure (preferably refractory metal) to withstand optimal operating temperatures (i.e., approaching 1500°K). Multiple bull's eye structures are formed in a multiplexed (overlapping) pattern and with different grating periods to produce a wide area beam having a broad emission spectrum.

FIG. 1

EP 2 908 430 A1

**Description**

FIELD OF THE INVENTION

This invention relates to apparatus and methods for emitting radiant energy.

BACKGROUND OF THE INVENTION

Thermophotovoltaic (TPV) energy conversion involves the conversion of heat to electricity, and has been identified as a promising technology since the 1960's. A basic TPV system includes a thermal emitter and a photovoltaic diode receiver. The thermal emitter is typically a piece of solid material or a specially engineered structure that generates thermal emission when heated to a high temperature (i.e., typically in a range from about 1200°K to about 1500°K). Thermal emission is the spontaneous radiation (emission) of photons due to thermal motion of charges in the thermal emitter material. For normal TPV system operating temperatures, the radiated photons are mostly at near infrared and infrared frequencies. The photovoltaic diode receiver includes a photovoltaic (PV) cell positioned to absorb some of these radiated photons, and is constructed to convert the absorbed photons into free charge carriers (i.e., electricity) in the manner typically associated with conventional solar cells. In effect, a solar energy system is a type of TPV energy conversion system where the sun acts as the thermal emitter. However, the present invention is directed to "earth-bound" TPV energy conversion systems in which the thermal emitter is solid structure that is heated from an external source (e.g., by concentrated sunlight or other heat generator).

Although TPV energy conversion is promising in theory, practical conventional TPV systems have achieved far lower efficiencies than theoretically predicted. A TPV system can be modeled as a heat engine in which the hot body (i.e., the heated thermal emitter) is described as a blackbody radiation source having a black body temperature $T_{BB}$, and the relatively cold PV receiver has a temperature $T_{PV}$, whereby the theoretical thermodynamic efficiency limit is given by the Carnot cycle $\eta_{Carnot} = (T_{BB}-T_{PV}) / T_{BB}$. For a thermal emitter temperature $T_{BB}$ equal to 1500°K and a PV receiver temperature $T_{PV}$ equal to 300°K, a theoretical efficiency $\eta_{Carnot}$ equals 0.8 (80%), which exceeds the Shockley-Queisser limit (i.e., the maximum theoretical efficiency of a solar cell using a p-n junction to collect power). In reality, however, the efficiencies of conventional TPV systems are reported to be below 10%. This is believed to stem from a mismatch between the spectrum of the thermal emitter and the PV cell.

One reason for the lower realized efficiencies of conventional TPV systems is related to carrier thermalization at high temperatures caused by a mismatch between the emitted photons and the PV cells. Thermal radiation from the thermal emitter (hot body) of a TPV system has a spectral power density given by Planck's law, and the peak wavelength $\lambda_{max}$ is given by Wien's law ($\lambda_{max} \sim (2898/ T_{BB})$ μm). For high-temperature emitters (1100°K $\leq T$BB $\leq$1500°K), the peak wavelength $\lambda_{max}$ is in the range of 1.9 to 2.6 μm, which requires the TPV system to utilize PV cells having low bandgap semiconductors (i.e., around 0.5-0.8 eV). Using such low bandgap PV cells requires the use of emitter materials having bandgaps closer to 0.5 eV (~2.5 μm) in order to obtain a larger fraction of in-band photons at reasonable emitter temperatures (i.e., 1100-1500°K). If emitter materials having bandgaps below 0.5 eV are used, the PV cell performance suffers from high carrier thermalization at the elevated temperatures required in TPV systems.

What is generally needed is a spectrally-selective emitter (spectral control element) capable of generating a narrowband, highly directional radiant energy beam that is selectively "tunable" (adjustable) to a desired peak emission wavelength. What is particularly needed is a spectrally-selective emitter for a TPV system that capable of transmitting only in-band photons to an associated PV cell (i.e., photons having wavelengths within the PV cell's EQE curve), and is capable of preventing out-of-band photons from reaching the PV cell, whereby efficiency of the TPV system would be greatly enhanced over conventional approaches.

SUMMARY OF THE INVENTION

The present invention is directed to a spectrally-selective metamaterial emitter including a novel bull's eye (circular target-shaped) structure that converts heat energy into a highly directional radiant energy beam having a narrow bandwidth (wavelength range). The bull's eye structure is integrally formed on a solid base substrate (wall), and includes concentric circular ridges that are separated by intervening grooves extending into (but not through) the planar base substrate, wherein each adjacent pair of concentric circular ridge structures is separated by the same "fixed" grating period. When the metamaterial emitter is heated to a suitable operating temperature (e.g., above 1000°K), surface plasmons generated on the concentric circular ridge structures produce a radiant energy beam. According to an aspect of the present invention, this emitted radiant energy beam is highly directional (i.e., 90% of the emitted radiant energy is within 0.5° of perpendicular to the planar substrate surface), narrow band (i.e., the full-width at half maximum of the emitted radiant energy is within 10% of the peak emission wavelength), and has a peak emission wavelength that is roughly equal to the fixed grating period separating each adjacent pair of concentric circular ridge structures (i.e., the peak emission wavelength is within 25% of the grating period). Accordingly, the metamaterial emitter of the present invention effectively provides a narrowband filter element (spectral control element) with a spectral response that is selectively "tunable" (adjustable) by way of adjusting the fixed grating period separating the concentric circular ridge structures that form the emitter's bull's eye structures.

By utilizing an appropriate fabrication techniques, the present invention provides metamaterial emitters that are usable for a wide range of purposes benefitting from highly directional, narrow bandwidth radiant energy beams. Depending on the intended use and practical limitations of available manufacturing systems, metamaterial structures can be produced having bull's eye structures with grating periods A of almost any practical size (e.g., in a range of less than one nanometer to ten meters. The present invention is described below with reference to specific embodiments in which metamaterial emitters are fabricated with bull's eye structures having a fixed grating period in the range of 10 nm and 5 microns using standard photolithography, whereby the metamaterial emitter emits radiant energy having peak emission wavelengths from 0.5 to 3 microns utilized by most low-bandgap photovoltaic (PV) cells. In a presently preferred embodiment, the metamaterial emitter is fabricated with one bull's eye structures having a fixed grating period in the range of 1.0 and 2.0 microns, whereby the metamaterial emitter emits radiant energy that is tuned to match the absorption curves of selected low-bandgap (e.g., GaSb) PV cells. However, those skilled in the art will recognize that metamaterial emitters fabricated using larger scale fabrication techniques (e.g., using computer numerical controlled milling machines) to include bull's eye structures having a much larger grating period to generate higher wavelength energy beams used, for example, to wirelessly transmit multispectral high power density energy beams to remote locations for tagging, tracking and locating targets in military applications. As such, the present invention is not limited to the smaller grating periods described in the specific examples set forth below.

According to an aspect of the present invention, the metamaterial emitter is constructed (fabricated) as an all-metal structure (i.e., both the base substrate and the bull's eye" structure are entirely formed using one or more metals). This all-metal construction is critical for withstanding the high operating temperatures (i.e., 1000 to 1500°K) without delamination (which can occur when one or more dielectric are used), and because the use of metal is required for exploiting surface plasmons. In a specific embodiment, the all-metal structure (i.e., both the base substrate and the bull's eye" structure) is formed using one or more refractory metals (e.g., Rhenium, Tantalum or Tungsten, or a refractory metal alloy including one or more refractory metals) because refractory metals are able to withstand the higher operating temperatures (i.e., approaching 1500°K) without melting or deforming. In a presently preferred embodiment, both the base substrate and the bull's eye" structure are entirely formed using Rhenium or a Rhenium alloy because the ability of this metal/alloys to withstand high temperatures is well known from their use in high-performance jet and rocket engines.

According to a specific embodiment of the present invention, a metamaterial emitter includes two or more bull's eye structures, each bull's eye structure having a different fixed grating period, whereby the total radiant energy emitted by the metamaterial emitter is effectively broadened by the two different peak emission wavelengths. In a specific embodiment, a large number of bull's eye structures are disposed in sets of two or more, with each set including a first bull's eye structure having a first fixed grating period and a second bull's eye structure having a second fixed grating period, wherein the second fixed grating period is larger than the first fixed grating period such that first radiant energy emitted from said first bull's eye structure has a first peak emission wavelength that is greater than a second peak emission wavelength of second radiant energy emitted from the second bull's eye structure. In an exemplary embodiment, each set includes three bull's eye structures respectively having concentric circular ridges that are formed with corresponding fixed grating periods from 1 to 3 microns. Providing a large number of bull's eye structures disposed in sets having two or more different grating periods facilitates selective broadening of a metamaterial emitter's total emission spectrum, for example, to increase the number of in-band photons transmitted to a corresponding PV cell used to convert the emitted radiation into electricity.

In another specific embodiment, a metamaterial emitter is configured to include an array of bull's eye structures arranged in a multiplexed (overlapping) pattern (i.e., such that at least some of the concentric circular ridge structures of each bull's eye structure intersect at least some of the concentric circular ridge structures of an adjacent bull's eye structure, thereby concentrating the emitted radiant energy to increase spectral bandwidth. Further, by disposing the bull's eye structures in sets having different fixed grating periods, as described above, the metamaterial emitter both concentrates and combines adjacent narrowband spectra to produce a high energy emission with a broader overall spectrum that can be used, for example, to maximize the number of in-band photons converted by a target PV cell, thereby maximizing the PV cell's output power density.

According to an exemplary practical embodiment of the present invention, a metamaterial emitter includes an all-metal box-like enclosure formed by a peripheral wall, with one or more bull's eye structures disposed as described above on at least one outward facing surface of the peripheral wall (i.e., such that at least one radiant energy beams is emitted in at least one direction from the metamaterial emitter). The peripheral wall surrounds a substantially rectangular interior cavity and includes an inlet opening through which heat energy (e.g., concentrated sunlight or heat from a combustion process) is supplied into the cavity during operation, and an outlet opening through which waste heat is allowed to exit the cavity. Each bull's eye structure is configured such that, when sufficient heat energy is supplied into the interior cavity to heat the peripheral wall to a temperature above 1000°K, radiant energy is emitted from the bull's eye structure in the manner described above. The box-like enclosure is constructed as an all-metal structure (i.e., constructed solely of metal) to facilitate generating the required high operating temperatures (i.e., 1000 to 1500°K) over a suitable operating lifetime of the metamaterial emitter. In a specific embodiment, the all-metal box-like enclosure is formed entirely from refractory metals (e.g., Rhenium, Tantalum or Tungsten) or refractory metal alloys to further enhance the enclosure's operational lifetime. In a preferred embodiment, at least one bull's eye structure is disposed on the outward-facing surfaces of two opposing flat (planar) peripheral wall portions, thereby generating two radiant energy beams that are directed in different directions from the metamaterial emitter. This arrangement provides optimal energy beam generation because the flat/planar wall surfaces facilitate cost-effective fabrication of the bull's eye structures (i.e., using existing photolithographic fabrication techniques), and the rectangular-shaped interior cavity defined between the two opposing flat peripheral wall portions facilitates efficient transfer of heat energy (e.g., by allowing concentrated sunlight to reflect between the opposing interior surfaces as it propagates along the interior cavity).

In yet another specific embodiment optimized for converting concentrated solar energy into infrared emissions, the all-metal box-like enclosure is configured to channel solar energy into the interior cavity defined between the two opposing peripheral wall portions in a manner that maximizes the transfer of heat energy to the peripheral wall portions, which in turn maximizes the amount of radiant energy emitted from the bull's eye structures formed on the respective outward-facing surfaces. First, a compound parabolic trough is formed by corresponding metal structures that are respectively integrally connected to corresponding front end portions of the opposing peripheral wall portions, wherein the compound parabolic trough is operably shaped to channel concentrated sunlight through the inlet opening into the interior cavity such that it reflects between the inside surfaces of the two opposing peripheral wall portions. In addition, a funnel-shaped outlet is formed by corresponding metal structures respectively integrally connected to the rear end portions of the peripheral wall portions that releases waste heat from interior cavity through the outlet opening in a manner that enhances energy transfer to the bull's eye structures. Moreover, to maximize the amount of emitted radiant energy, multiple multiplexed bull's eye structures are formed in arrays as described above on the outward-facing surfaces of the peripheral wall portions. Finally, to minimize thermal cycling stresses and to maximize the operating lifetime of the metamaterial emitter, the entire all-metal box-like enclosure (i.e., including the peripheral wall portions, the compound parabolic trough structures, and the funnel-shaped outlet structures) are constructed using a single refractory metal (e.g., Rhenium, Tantalum or Tungsten), or a refractory metal alloy (e.g., Rhenium alloy).

In yet another embodiment of the present invention, a spectrally-selective metamaterial emitter is fabricated by generating a patterned mask on a planar surface of a refractory metal substrate by way of photolithography such that the patterned mask includes concentric circular resist structures having a fixed grating period in the range of 0.5 microns to 5 microns, then utilizing the mask to form concentric circular refractory metal ridge structures on the planar surface having the fixed grating period. In alternative embodiments, the concentric circular ridge structures are formed either using an additive process (e.g., where refractory metal, which can be the same or different from the base substrate, is deposited by way of sputtering or other technique into slots formed in the mask) or a subtractive process (e.g., where the base substrate is dry etched through the mask slots, whereby the concentric ridge structures comprise the same refractory metal as the base substrate). After forming the concentric circular ridge structures, the mask is removed to expose the intervening concentric circular grooves separating the ridges. To generate multiplexed bull's eye structures, the mask is formed with concentric circular resist structures disposed in the desired multiplexed arrangement.

BRIEF DESCRIPTION OF THE DRAWINGS

These and other features, aspects and advantages of the present invention will become better understood with regard to the following description, appended claims, and accompanying drawings, where:

Fig. 1 is a perspective view showing a partial metamaterial emitter according to an embodiment of the present invention;

Fig. 2 is a perspective view showing a metamaterial emitter according to a second embodiment of the present invention;

Figs. 3(A), 3(B) and 3(C) are cross-sectional side views taken along section lines 3A-3A, 3B-3B and 3C-3C, respectively, of Fig. 2 showing bull's eye structures with different fixed grating periods;

Fig. 4 is a perspective view showing a metamaterial emitter according to a third embodiment of the present invention;

Fig. 5 is a perspective view showing a metamaterial emitter according to a fourth embodiment of the present invention;

Figs. 6(A) and 6(B) are perspective and cross-sectional side views, respectively, showing a metamaterial emitter according to a fifth embodiment of the present invention;

Fig. 7 is a photograph showing an exemplary bull's eye pattern utilized on the metamaterial emitter of Figs. 6(A) and 6(B);

Figs. 8(A), 8(B), 8(C), 8(D), 8(E) and 8(F) are simplified cross-sections illustrating a method for fabricating bull's eye structures according to another embodiment of the present invention;

Fig. 9 is an enlarged photograph showing a bull's eye structure produced in accordance with the methodology of Figs. 8(A) to 8(F); and

Fig. 10 is a graph depicting spectral characteristics of radiant energy generated by the bull's eye structure of Fig. 9.

DETAILED DESCRIPTION OF THE DRAWINGS

The present invention relates to an improvement in apparatus used to emit radiant energy. The following description is presented to enable one of ordinary skill in the art to make and use the invention as provided in the context of a particular application and its requirements. As used herein, directional terms such as "upper", "upward", "lower" "downward" "over" "front" and "rear", are intended to provide relative positions for purposes of description, and are not intended to designate an absolute frame of reference. In addition, the phrases "integrally formed" and "integrally connected" are used herein to describe the connective relationship between two portions of a single fabricated or machined structure, and are distinguished from the terms "connected" or "coupled" (without the modifier "integrally"), which indicates two separate structures that are joined by way of, for example, adhesive, fastener, clip, or movable joint. Various modifications to the preferred embodiment will be apparent to those with skill in the art, and the general principles defined herein may be applied to other embodiments. Therefore, the present invention is not intended to be limited to the particular embodiments shown and described, but is to be accorded the widest scope consistent with the principles and novel features herein disclosed.

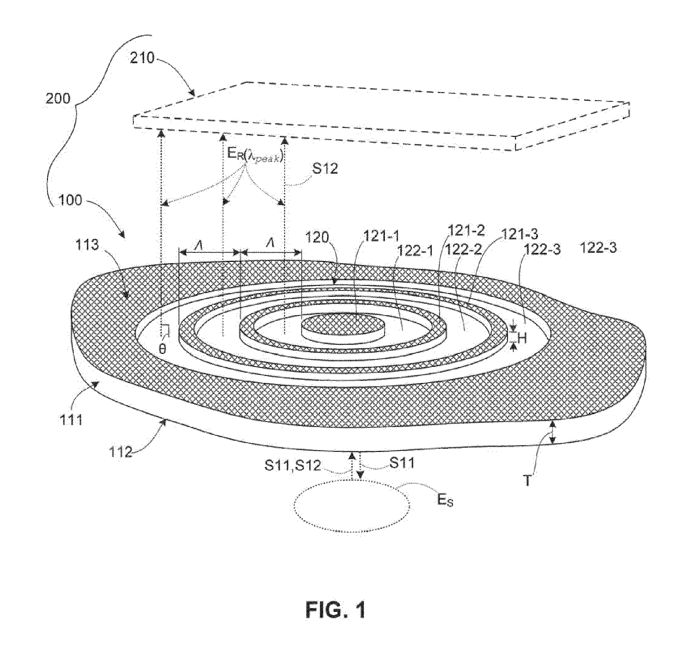

Fig. 1 is a perspective top view showing a portion of a spectrally-selective metamaterial emitter 100 including a bull's eye structure 120 disposed on a base substrate 111. To illustrate the directionality of a radiant energy beam $E_R$ emitted from bull's eye structure 120, emitter 100 is depicted as part of a thermophotovoltaic (TPV) converter 200 including a photovoltaic (PV) cell "target" 210 (shown in dashed lines above metamaterial emitter 100), but emitter 100 is not restricted to TPV converters.

Base substrate 111 is a solid (wall-like) plate having a planar lower (first) surface 112 and an opposing planar upper (second) surface 113 on which bull's eye structure 120 is integrally formed. During operation, lower surface 112 faces a source of heat energy $E_S$, and upper surface 113 faces away from the heat energy source. Base substrate 111 is preferably entirely constructed from metal, and more preferably is entirely constructed using one or more refractory metals (e.g., Rhenium, Tantalum, or Tungsten), or a refractory metal alloy (e.g., Rhenium alloy). In an exemplary practical exemplary embodiment (e.g., when used as part of TPV system 200), base substrate 111 has a thickness T on the order of more than a wavelength of emitted radiant energy $E_R$ (described below), but may have any arbitrary thickness outside of this constraint.

Bull's eye structure 120 includes concentric circular ridge structures 121-1, 121-2 and 121-3 that are integrally formed on upper surface 113 of base substrate 111 (i.e., either formed from the same material as base substrate 111 by a subtractive process such as etching or milling, or formed by an additive process such as sputtering that effectively melds (fuses) the added material to the base substrate material). Ridge structures 121-1, 121-2 and 121-3 are respectively separated by intervening circular grooves 122-1, 122-2 and 122-3 that extend into (but not through) base substrate 111 such that each adjacent pair of ridge structures is separated by a fixed grating period (pitch distance) A. For example, ridge structures 121-1 and 121-2 are separated by circular groove 122-1 such that the distance between an outside edge of ridge structure 121-1 and and outside edge of ridge structure 121-2 is equal to the grating period A. Similarly, ridge structures 121-2 and 121-3 are separated by circular groove 122-2 such that the distance between an outside edge of ridge structure 121-2 and and outside edge of ridge structure 121-3 is equal to the same grating period A as that separating ridge structures 121-1 and 121-2. Ridge structures 121-1 to 121-3 comprise metal that may be different from the material that forms base substrate 111, but preferably both the ridge structures and the base substrate comprise the same metal material to avoid thermal mismatch issues.

According to an aspect of the present invention, bull's eye structure 120 is configured such that, when heat energy $E_S$ is applied to lower surface 112 and is sufficient to heat base substrate 111 to a temperature above 1000°K, radiant energy $E_R$ is emitted from upper surface 113 having a peak emission wavelength $\lambda_{peak}$ that is roughly equal to (i.e., within 25% of) fixed grating period A. According to another aspect of the present invention, emitted radiant energy beam $E_R$ is highly directional (i.e., 90% of the emitted radiant energy is within 0.5° of perpendicular (angle $\theta$) to the planar outward-facing surface 113), narrow band (i.e., the full-width at half maximum of the emitted radiant energy is within 10% of peak emission wavelength $\lambda_{peak}$), and peak emission wavelength $\lambda_{peak}$ that is roughly equal to the fixed grating period $\Lambda$ separating each adjacent pair of concentric circular ridge structures (i.e., the peak emission wavelength is within 25% of the grating period $\Lambda$). Accordingly, metamaterial emitter 100 is selectively "tunable" (adjustable) by way of adjusting the fixed grating period $\Lambda$ separating the concentric circular ridge structures 121-1 to 121-3.

The relationship between the specific geometric dimensions associated with bull's eye structure 120 and the characteristics of emitted radiant energy beam $E_R$ are explained mathematically as follows. From a generalized diffraction theory (Bloch theorem/Floquet condition), the two-dimensional grating equation associated with bull's eye structure 120 is representable using Equation (1):

$$\frac{2\pi}{\lambda}\sin\theta = \frac{2\pi}{\Lambda}m - k_{spp} \quad \text{(Equation 1)}$$

where $\lambda$, $m$ and $\Lambda$ are emission wavelength, an integer diffraction order and the grating period, respectively. The term $k_{spp}$, which is the surface plasmons wavevector on stratified metal-dielectric structure, can be expressed as:

$$k_{spp} = \frac{2\pi}{\lambda}\sqrt{\frac{\varepsilon_d\varepsilon_m}{\varepsilon_d + \varepsilon_m}} \quad \text{(Equation 2)}$$

where $\varepsilon_d$ and $\varepsilon_m$ are the permittivities of the dielectric and metal, respectively. Here, the dielectric material is air, with $\varepsilon_d = 1$. For emission on axis ($\theta = 0°$ deflection), the grating wavevector $k_{grating}$ has to be phase-matched to the surface plasmons wavevector, i.e. $k_{grating} = 2\pi / \Lambda = k_{spp}$. Thus, the peak emission wavelength $\lambda_{peak}$ or radiant energy beam $E_R$ is roughly equal to the grating period $\Lambda$ separating concentric circular ridge structures 121-1 to 121-3.

Referring again to Fig. 1, other geometric features of bull's eye structure 120 also contribute to emitted radiant energy beam $E_R$. For example, the height H of ridge structures 121-1 to 121-3 (i.e., the depth of grooves 122-1 to 122-3) contributes to the quality of emitted beam, and is preferably set in relation to the peak emission wavelength $\lambda_{peak}$. In one embodiment, height H is approximately $\lambda/10$, which is much smaller than the wavelength $\lambda_{peak}$, but still sufficiently deep to allow coupling of the incident light in and out of the surface plasmons. Grooves 122-1 to 122-3 can also be deep, with an upper limit of approximately $\lambda/2$. In this scenario, cavity modes are also excited inside the grooves that contribute to spectrally cleaning up the beam.

By constructing metamaterial emitter 100 using the specifications set forth above, the present invention effectively facilitates a mechanism for generating radiant energy having a spectral response that is selectively "tunable" (adjustable) by way of changing the fixed grating period $\Lambda$. That is, if a radiant beam having a relatively small/short peak wavelength is required for a particular application, then a first metamaterial emitter with a relatively small fixed grating period is fabricated as described above using appropriate techniques (e.g., photolithography). If the first emitter is found to generate radiant energy whose peak wavelength is non-optimal (e.g., too low), then a second metamaterial emitter with an appropriately adjusted (e.g., larger) fixed grating period can be fabricated to effectively "tune" the radiant energy to the optimal peak wavelength. Conversely, if a radiant beam having a relatively large/long peak wavelength is required, then a second metamaterial emitter with a relatively small fixed grating period can fabricated as described above using appropriate large-scale fabrication techniques (e.g., CNC machining).

Depending on the intended use and practical limitations of available manufacturing systems, a bull's eye structure of the present invention can have a grating period $\Lambda$ almost any practical size (e.g., in a range of less than one nanometer to ten meters. In the exemplary practical embodiment depicted in Fig. 1 (e.g., when used as part of TPV system 200 including a low-bandgap PV cell 210), ridge structures typically has a grating period A in the range of 0.5 microns and 2.5 microns, which corresponds with the absorption curves of most commercially available PV cells. In a particularly preferred embodiment (e.g., when PV cell 210 is a GaSb PV cell), emitter 100 is produced with a grating period A in the range of 1.0 microns and 2.0 microns.

According to another aspect of the present invention, metamaterial emitter 100 effectively functions as a narrowband filter element (spectral control element) that only passes in-band photons to an associated target (e.g., photons having wavelengths within the EQE curve of a target PV cell), and is capable of preventing out-of-band photons from reaching the target. This filtering function is illustrated in Fig. 1, where the broadband characteristics of the photons associated with heat energy $E_S$ are identified using S-parameter S11 to indicate out-of-band photons, and S-parameter S12 to indicate in-band photons. Because bull's eye structure 120 is "tuned" to the EQE curve of PV cell 210, metamaterial emitter 100 effectively "passes" in-band photons S12 to PV cell 120. Conversely, the all-metal structure of metamaterial emitter 100 forms a type of barrier between heat energy $E_S$ and PV cell 210 that effectively "blocks" (i.e., prevents out-of-band photons S12 from reaching the PV cell. Note that this filtering functionality would not be possible if base substrate 111 were not a solid sheet (i.e., if the substrate included holes that allowed both S11 and S12 to pass through). By passing only in-band photons to an associated target PV cell, the present invention greatly increases the efficiency of a TPV converter over conventional approaches. Additional information regarding the benefit of metamaterial emitter 100 in conjunction with a TPV converter 200 is described in co-owned and co-pending U.S. Patent Application Serial Number xx/xxx,xxx, entitled "Metamaterial Enhanced Thermophotovoltaic Converter" [Atty Docket No. 20131311US02 (XCP-186-2)], which is incorporated herein by reference in its entirety.

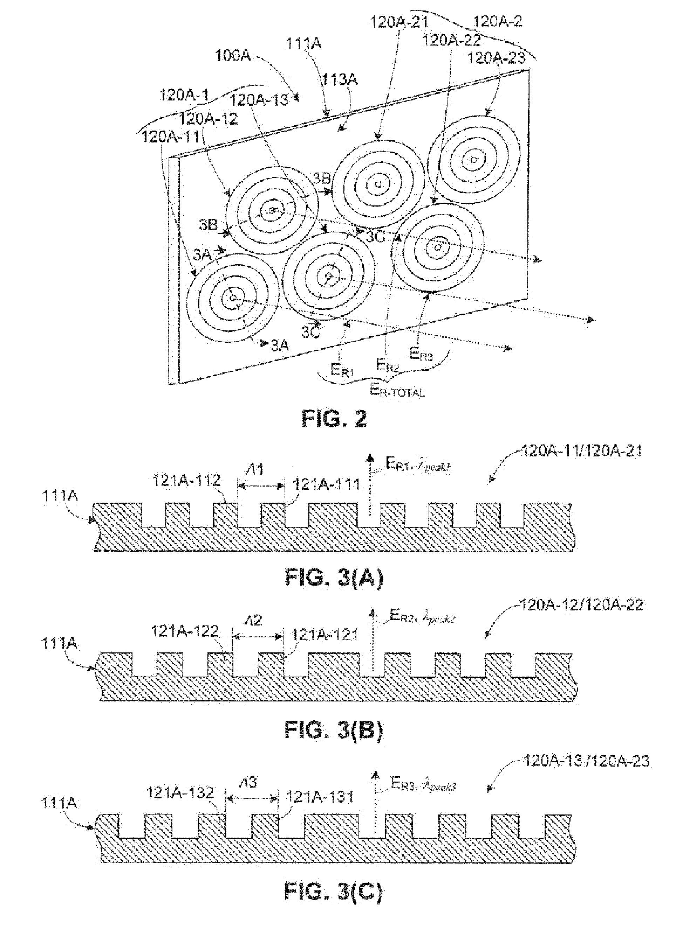

Fig. 2 is a simplified perspective view showing a metamaterial emitter 100A includes multiple bull's eye structures 120A-11 to 120A-13 and 120A-21 to 120A-23 that are formed on a "target-facing" surface 113A of a base substrate 111A in a manner similar to that described above. Figs. 3(A) to 3(C) are cross-sectional views taken along section lines 3A-3A, 3B-3B, and 3C-3C of Fig. 2.

Metamaterial emitter 100A is characterized in that it utilizes multiple bull's eye structures arranged in sets of three, where each bull's eye structure of each set has a different fixed grating period to effectively broaden a total radiant energy beam $E_{R\text{-}TOTAL}$ emitted by the metamaterial emitter 100A. Referring to Fig. 2, the multiple bull's eye structures are arranged in two sets 120A-1 and 120A-2, where each set includes three bull's eye structures (i.e., set 120A-1 includes bull's eye structures 120A-11 to 120A-13, and set 120A-2 includes bull's eye structures 120A-21 to 120A-23). Each set 120A-1 and 120A-2 includes one bull's eye structure having grating period $\Lambda1$, one bull's eye structure having grating period $\Lambda2$, and one bull's eye structure having grating period $\Lambda3$. Specifically, as indicated in Fig. 3(A), set 120A-1 includes structure 120A-11 having concentric circular ridge structures spaced at a fixed grating period $\Lambda1$ (e.g., the distance between adjacent structures 121A-111 and 121A-112 is equal to grating period $\Lambda1$). Fig. 3(A) also represents bull's eye structure 210A-22 of set 120A-2, which includes ridge structures having fixed grating period $\Lambda1$ formed in the same manner depicted by adjacent structures 121A-111 and 121A-112. Similarly, Fig. 3(B) shows that both structure 120A-12 of set 120A-1 and structure 210A-22 of set 120A-2 have grating period $\Lambda2$ (e.g., as depicted by adjacent structures 121A-121 and 121A-122, which are separated by grating period $\Lambda2$), and Fig. 3(C) shows that both structure 120A-13 of set 120A-1 and structure 210A-23 of set 120A-2 have grating period $\Lambda3$ (e.g., as depicted by adjacent structures 121A-131 and 121A-132, which are separated by grating period A3).

The benefit of forming metamaterial emitter 100A with three different grating periods is that this approach can be used to selectively broaden the overall spectrum of the total radiant energy beam $E_{R\text{-}TOTAL}$ emitted by metamaterial emitter 100A. That is, because the radiant energy generated by a particular bull's eye structure is related to its fixed grating period, a broadened the total radiant energy beam $E_{R\text{-}TOTAL}$ is generated by emitter 100A (shown in Fig. 2) by utilizing three different grating periods $\Lambda1$, $\Lambda2$ and $\Lambda3$. For example, assume fixed grating period $\Lambda3$ is larger than fixed grating period $\Lambda2$, and fixed grating period $\Lambda2$ is larger than fixed grating period $\Lambda1$. As indicated in Figs. 3(A) to 3(C), these different grating periods generate component radiant energy beams to having different peak emission wavelengths. That is, because fixed grating period $\Lambda3$ is greater than fixed grating period $\Lambda2$, component radiant energy beams $E_{R3}$ emitted from bull's eye structures 120-13 and 120-23 have a peak emission wavelength $\lambda_{peak3}$ that is greater than a peak emission wavelength $\lambda_{peak2}$ of radiant energy $E_{R2}$ generated by bull's eye structures 120-12 and 120-22. Similarly, the peak emission wavelength $\lambda_{peak2}$ of radiant energy beam $E_{R2}$ is greater than a peak emission wavelength $\lambda_{peak1}$ of radiant energy $E_{R1}$ generated by bull's eye structures 120-11 and 120-21). Referring again to Fig. 2, the total radiant energy beam $E_{R\text{-}TOTAL}$ is a combination of component radiant energy beams $E_{R1}$, $E_{R2}$ and $E_{R3}$, and the effect of combining the adjacent narrowband spectra of component beams $E_{R1}$,

$E_{R2}$ and $E_{R3}$ is to broaden the overall spectrum of total radiant energy beam $E_{R\text{-}TOTAL}$. A practical use of this approach is, for example, to provide more in-band photons to a target PV cell used to convert the emitted radiation into electricity, and consequently to increase the output power density of a TPV system.

The approach set forth above with reference to Figs. 2 and 3(A) to 3(C) is extendible to any number of fixed grating periods in order to selectively broaden the overall spectrum of a total radiant energy beam. That is, although the approach is described with reference to six bull's eye structures disposed in two sets of three that utilize three different grating periods, it is understood that the approach is extendable to any number of bull's eye structures disposed in any number of sets of two or more bull's eye structures. For example, a metamaterial emitter may include only two grating periods to facilitate the emission of a relatively narrow emission spectrum, or a spectrum having two separated "peak" emission wavelengths. Alternatively, the use of a large number of grating periods facilitates the emission of a relatively broad emission spectrum. It is also possible to fabricate a metamaterial emitter that in which all bull's eye structures have a unique fixed grating period (i.e., no two bull's eye structures have the same grating period). Unless otherwise specified, the appended claims are intended to cover all of the above-mentioned combinations of different grating periods.

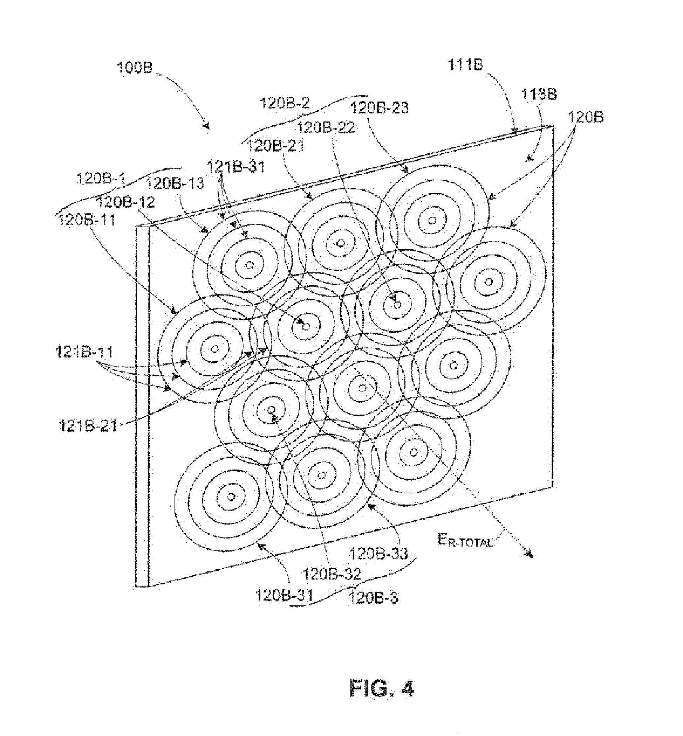

Fig. 4 is a perspective view showing a metamaterial emitter 100B including multiple bull's eye structures formed on a "target-facing" surface 113B of a base substrate 111B in a manner similar to that described above. Metamaterial emitter 100B differs from the previous embodiments in that the multiple bull's eye structures are formed in a "multiplexed" (overlapping) pattern (i.e., such that at least some of the circular ridge structures of one bull's eye structure intersect at least some of the circular ridge structures of at least one adjacent bull's eye structure). For example, referring to the upper left corner of Fig. 4, bull's eye structure 120B-11 includes a first group of concentric circular ridge structures 121B-11, and adjacent bull's eye structure 120B-12 includes a second group of concentric circular ridge structures 121-12. Bull's eye structures 120B-11 and 120B-12 form a multiplexed pattern in that at least some of circular ridge structures 121B-11 of bull's eye structure 120B-11 intersect (overlap) at least some of circular ridge structures 121B-12 of bull's eye structure 120B-12. This multiplex pattern serves to concentrate radiant energy $E_{R\text{-}TOTAL}$ emitted by metamaterial emitter 100B, which can be used, for example, to provide more in-band photons to a target PV cell used to convert the emitted radiation into electricity, and consequently to increase the output power density of a TPV system.

According to a presently preferred embodiment, in addition to the multiplexed pattern, metamaterial emitter 100B is also fabricated to employ the multiple-grating-period approach described above with reference to Fig.

2 (i.e., such that at least one bull's eye structure has a fixed grating period that is different (e.g., larger) than the fixed grating period of another bull's eye structure). By way of example, the various multiplexed bull's eye structures of metamaterial emitter 100B are shown as being arranged in three sets: a first set 120B-1 including bull's eye structures 120B-11, 120B-12 and 120B-13, a second set 120B-2 including bull's eye structures 120B-21, 120B-22 and 120B-23, and a third set 120B-3 including bull's eye structures 120B-31, 120B-32 and 120B-33. Each set includes one bull's eye structure having a common first grating period (i.e., bull's eye structures 120B-11, 120B-21 and 120B-31 are fabricated using the same grating period in the manner described above with reference to Fig. 3(A)), one bull's eye structure having a second grating period (i.e., bull's eye structures 120B-12, 120B-22 and 120B-32 are fabricated in the manner described above with reference to Fig. 3(B)), and one bull's eye structure having a third grating period (i.e., bull's eye structures 120B-13, 120B-23 and 120B-33 are fabricated in the manner described above with reference to Fig. 3(B)). With this arrangement, metamaterial emitter 100B generates total radiant energy $E_{R\text{-TOTAL}}$ that both concentrates and combines adjacent narrowband spectra to produce a high energy emission with a broader overall spectrum that can be used, for example, to maximize the number of in-band photons converted by a target PV cell, thereby maximizing the PV cell's output power density.

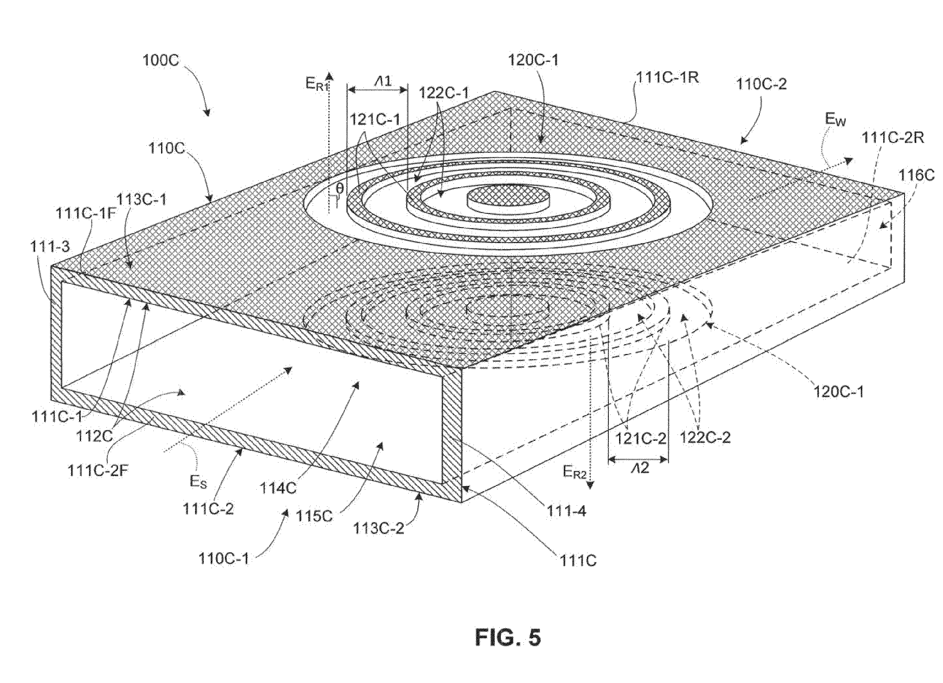

Fig. 5 is a perspective view showing a metamaterial emitter 100C in which the base substrate is formed as part of an all-metal box-like enclosure 110C that facilitates achieving optimal high operating temperatures (i.e., 1000°K to 1500°K). Box-like enclosure 110C includes a peripheral wall 111C having an upper (first) peripheral wall portion 111C-1 and a lower (second) peripheral wall portion 111C-2 that are connected by respective side wall portions in an opposing spaced-apart (e.g., parallel) relationship such that a substantially rectangular interior cavity 114C is defined between wall portions 111C-1 and 111C-2. Peripheral wall 111C includes an inward-facing surface 112C that faces an interior cavity 114C, and outward-facing surfaces 113C-1 and 113C-2 of wall portions 111C-1 and 111C-2, respectively, that face away from interior cavity 114C (i.e., upward and downward, respectively, from box-like enclosure 110C). Peripheral wall portions 111C-1 and 111C-2 extend between an inlet end 110C-1 and an outlet end 110C-2 of box-like enclosure 110C such that an inlet opening 115C is defined between respective front end portions 111C-1F and 111C-2F of peripheral wall portions 111C-1 and 111C-2, and an outlet opening 116C is defined between respective rear end portions 111C-1R and 111C-2R of peripheral wall portions 111C-1 and 111C-2. During operation, "source" heat energy $E_S$ is supplied into the interior cavity 114C through inlet opening 115C, and "waste" heat energy is evacuated through outlet opening 116C.

Metamaterial emitter 100C also includes one or more bull's eye structures, formed in the manner described above, that is/are disposed on one or more outward facing surfaces of peripheral wall 111C. As indicated in Fig. 5, bull's eye structure 120C-1 is disposed on upward-facing surface 113C-1 of upper peripheral wall portion 111C-1 and includes concentric circular ridge structures 121C-1 separated by intervening circular grooves 122C-1 and separated by a fixed grating period $\Lambda1$. The box-like enclosure arrangement provides optimal energy beam generation because flat/planar peripheral wall portion 111C-1 facilitates cost-effective fabrication of the bull's eye structures thereon (e.g., using existing photolithographic fabrication techniques), and because rectangular-shaped interior cavity 114C facilitates the efficient transfer of heat energy over the "base substrate" formed by peripheral wall portion 111C-1. In one embodiment, the rectangular box-like arrangement facilitates the transfer of heat energy in the form of concentrated sunlight that reflects between the opposing upper and lower interior surfaces 112C, thereby heating peripheral wall portion 111C-1, and allowing associated waste heat to be removed from interior cavity 114C through outlet opening 116C.

According to an aspect of the invention, box-like enclosure 110C is constructed as an all-metal structure (e.g., constructed from a single metal block or by welding or otherwise securing four metal plates together). The all-metal structure facilitates achieving the required high operating temperatures (i.e., 1000 to 1500°K) over a suitable operating lifetime of metamaterial emitter 100C. In a specific embodiment, the all-metal box-like enclosure 110C is formed entirely using one or more refractory metals (e.g., Rhenium, Tantalum or Tungsten) or refractory metal alloys to further enhance the enclosure's operational lifetime.

In a presently preferred embodiment, at least one bull's eye structure is disposed on each outward-facing surface 113C-1 and 113C-2 of opposing wall portions 111C-1 and 111C-2. This embodiment is illustrated by bull's eye structure 120C-1, which is formed on upward-facing surface 113C-1, and optional bull's eye structure 120C-2, which is shown in dashed line as being disposed on downward-facing surface 113C-2. Similar to bull's eye structure 120C-1, bull's eye structure 120C-2 includes concentric circular ridge structures 121C-1 separated by intervening circular grooves 122C-1 and separated by a fixed grating period $\Lambda2$, which in this embodiment is either the same as or different from fixed grating period A1. With this arrangement, when heat energy $E_S$ is supplied into the interior cavity 114C and is sufficient to heat peripheral wall 111C to a temperature above 1000°K, radiant energy $E_{R1}$ is emitted upward from box-like enclosure 110C having a peak emission wavelength that is roughly equal to the fixed grating period A1, and at the same time, heat energy $E_S$ causes bull's eye structure 120C-2 to emit radiant energy $E_{R2}$ downward from box-like enclosure 110C having a peak emission wavelength that is roughly equal to the fixed grating period *Λ*2. This arrangement facilitates the generation of additional radiant energy that may be used, for example, to facilitate increased electricity generation in a TPV system (i.e., by placing a second PV cell below emitter 100C to capture radiant energy beam $E_{R2}$).

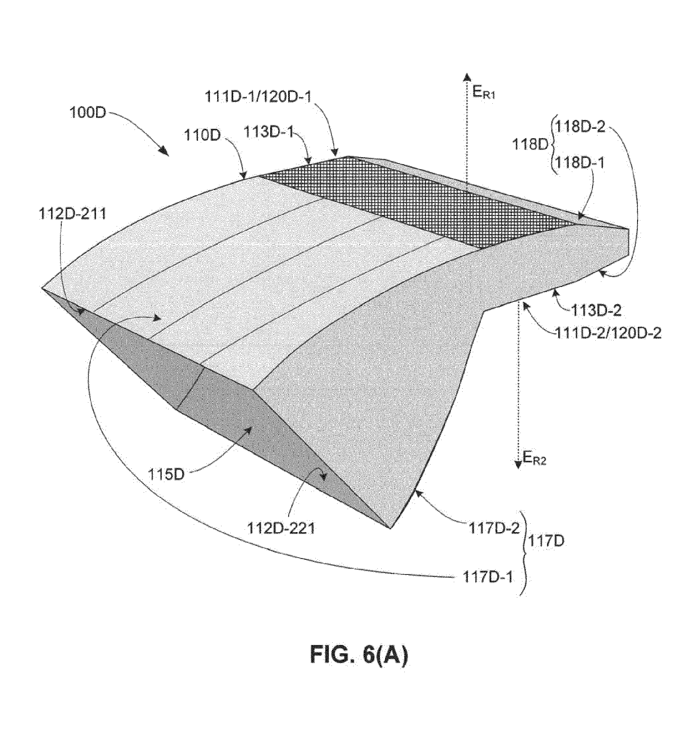

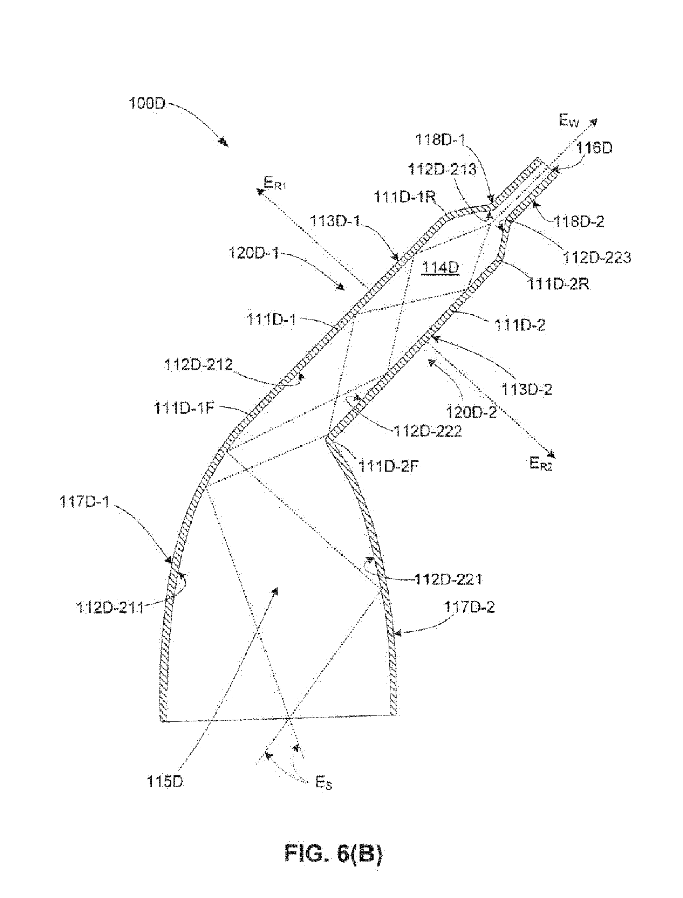

Figs. 6(A) and 6(B) are perspective and cross-sectional side views showing a metamaterial emitter 100D including an all-metal box-like enclosure 110D that is configured for use in a solar tower power harvesting system such as that described in co-owned and co-pending U.S. Patent Application Serial Number xx/xxx,xxx, entitled "Solar Tower Power Harvesting System With Metamaterial Enhanced Solar Thermophotovoltaic Converter (MESTC)" [Atty Docket No. 20131311US03 (XCP-186-3)], which is incorporated herein by reference in its entirety.

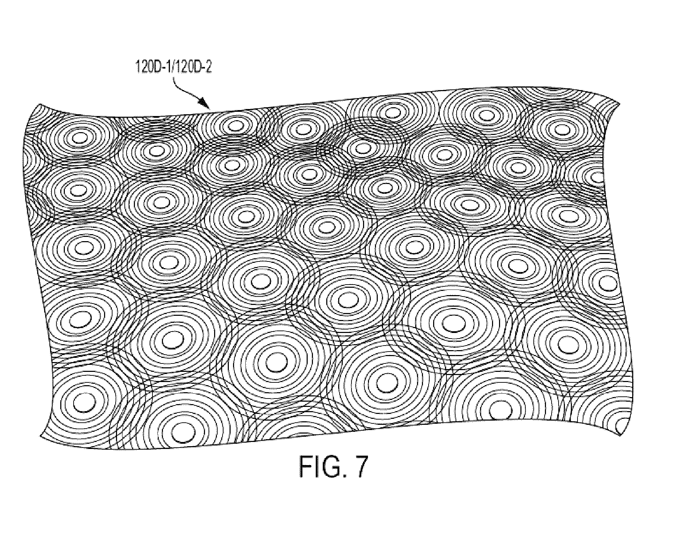

Metamaterial emitter 100D is similar to that described above with reference to Fig. 5 in that box-like enclosure 110D includes opposing upper (first) and lower (second) peripheral wall portions 111D-1 and 111D-2 that are connected by respective side wall portions in an opposing spaced-apart (e.g., parallel) relationship, and such that arrays 120D-1 and 120D-2 of bull's eye structures are respectively formed on outward-facing surfaces 113D-1 and 113D-2 of wall portions 111D-1 and 111D-2. Bull's eye structure arrays 120D-1 and 120D-2 are implemented using any of the various arrangements described above, but preferably include a multiplexed arrangement such as that shown in Fig. 7 to maximize the amount of energy transmitted in emitted radiant energy beams $E_{R1}$ and $E_{R2}$.

Metamaterial emitter 100D differs from previous embodiments in that it includes a compound parabolic trough 117D disposed at the inlet end of box-like enclosure 110D. As indicated in Fig. 6(B), the compound parabolic trough includes an upper (first) compound parabolic trough structure 117D-1 integrally connected to a front end portion 111D-1F of upper peripheral wall portion 111D-1, and a lower (second) compound parabolic trough structure 117D-2 integrally connected to a front end portion 111D-2F of lower peripheral wall portion 111D-2. As indicated by the dashed-line arrows in Fig. 6(B), compound parabolic trough structures 117D-1 and 117D-2 are operably shaped to channel concentrated sunlight $E_S$ through the inlet opening 115D into interior cavity 114D between peripheral wall portions 111D-1 and 111D-2 such that the sunlight reflects between the inside surfaces 112D-212 and 112D-222 of peripheral wall portions 111D-1 and 111D-2 in a manner that maximizes the transfer of heat energy to bull's eye structure arrays 120D-1 and 120D-2, which in turn maximizes the amount of radiant energy emitted in beams $E_{R1}$ and $E_{R2}$ respectively emitted from bull's eye structure arrays 120D-1 and 120D-2.

Metamaterial emitter 100D also differs from previous embodiments in that it includes a funnel-shaped outlet 117D disposed at the outlet end of box-like enclosure 110D that serves to control the release of "waste" heat from interior cavity 114D. As indicated in Fig. 6(B), the funnel-shaped outlet includes an upper (first) funnel-shaped outlet structure 118D-1 integrally connected to a rear end portion 111D-1R of upper peripheral wall portion 111D-1, and a lower (second) funnel-shaped outlet structure 118D-2 integrally connected to a rear end portion 111D-2R of lower peripheral wall portion 111D-2. As indicated by the dashed-line arrows in Fig. 6(B), funnel-shaped outlet structures 118D-1 and 118D-2 are operably shaped to channel "waste" heat energy Ew from interior cavity 114D through outlet opening 116D at a rate that optimizes energy transfer to bull's eye structure arrays 120D-1 and 120D-2.

For reasons similar to those set forth above (e.g., to minimize thermal cycling stresses and to maximize the operating lifetime) the entirety of all-metal box-like enclosure 110D (i.e., including peripheral wall portions 111D-1 and 111D-2, compound parabolic trough structures 117D-1 and 117D-2, and funnel-shaped outlet structures 118D-1 and 118D-2) is constructed using metal, and more preferably using a single refractory metal (e.g., Rhenium, a Rhenium alloy, Tantalum or Tungsten).

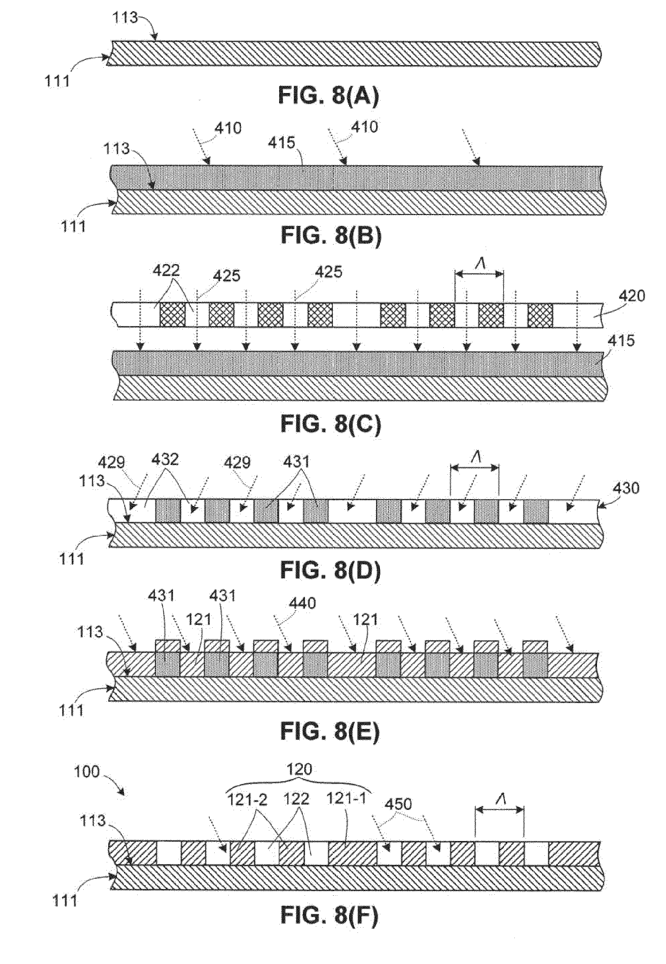

Figs. 8(A) to 8(F) are simplified cross-sections illustrating a method for fabricating bull's eye structures according to another embodiment of the present invention. Because most PV cells efficiently convert photons having wavelengths in the infrared (IR) range into electricity, it is desirable to construct a metamaterial structure whose peak emission wavelength matches the PV cell's IR-range bandgap. As set forth above, to achieve this objective, it is necessary to produce bull's eye structures having grating periods that roughly equal the IR-range bandgap (e.g., in the range of 0.5 to 5 microns). The process set forth in Figs. 8(A) to 8(F) provide a fabrication methodology that is capable of producing bull's eye structures having grating periods in the range of 0.5 to 5 microns using existing photolithographic systems, thereby minimizing manufacturing costs.

Figs. 8(A) to 8(D) illustrate the use of photolithography to generate a patterned mask on a planar upper surface 113 of a solid base substrate 111 (shown in Fig. 8(A). According to a preferred embodiment, base substrate 111 comprises one of the refractory metals (or alloys thereof) that are mentioned above. Fig. 8(B) shows the deposition of a photoresist 410 that forms a photoresist layer 415 on upper surface 113 of base substrate 111. Fig. 8(C) depicts the subsequent use of a reticle 420 to expose photoresist layer 415 using known techniques, but modified in that reticle includes an aperture pattern having a "mirror" shaped pattern corresponding to a "negative" of the desired bull's eye structures (i.e., including concentric circular apertures 422 set at a grating period in the range of 10 nanometers to 5 microns), whereby light 425 passing through apertures 422 develop corresponding concentric circular portions of photoresist layer 415. Fig. 8(D) show the subsequent removal of undeveloped photoresist (i.e., using a suitable etchant 429), thereby completing photoresist mask 430 including a plurality of concentric circular resist structures 431 having a fixed grating period $\Lambda$ in the range of 0.5 to 5 microns, wherein each adjacent pair of concentric circular resist structures 431 are separated by an intervening concentric circular slot 432.

Fig. 8(E) depicts utilizing mask 430 to form a bull's eye structure on upper surface 113 according to a specific "additive" embodiment of the present invention. In this case, a refractory metal 440 (which can either be the same refractory metal as forming base substrate 111 or a different refractory metal) is deposited (e.g., by way of sputter deposition) over mask 430 and exposed portions of upper surface 113 that are exposed between concentric circular resist structures 431, thereby forming ridge structures 121 having the fixed grating period A between adjacent pairs of resist structures 431. In an alternative "subtractive" embodiment (not shown), mask 430 is utilized to form bull's eye structures by dry etching exposed portions of the base substrate through the mask slots, thereby forming the concentric grooves between corresponding circular ridge structures 121-2 that have a composition identical to that of the base substrate.

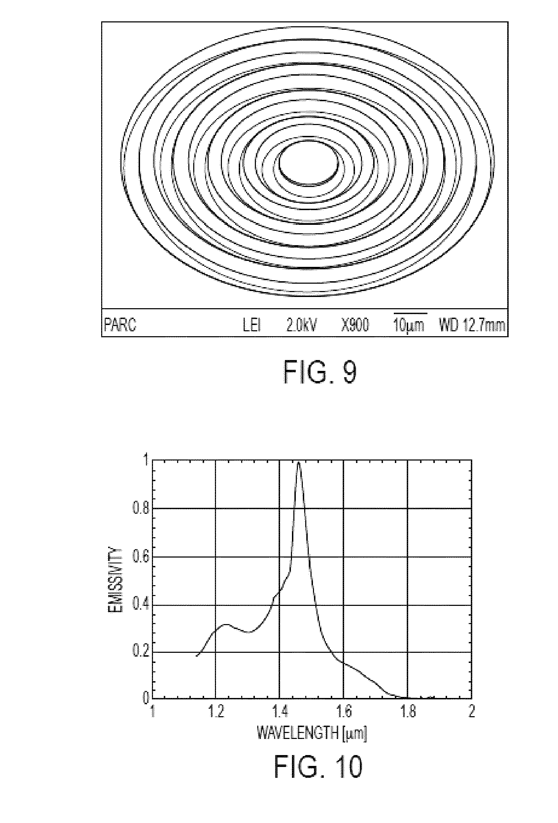

Fig. 8(F) depicts the subsequent removal of the photoresist mask from the planar upper surface 113 using a suitable etchant 250, thereby completing the fabrication of metamaterial emitter 100 including a bull's eye structure 120 disposed on base substrate 111, where bull's eye structure 120 includes concentric circular ridge structures 121-2 separated by intervening circular grooves 122 and spaced at a grating period A in the range of 0.5 to 5 microns. Fig. 9 is an enlarged photograph showing an actual bull's eye structure formed in accordance with the fabrication method set forth above. At high temperature, this structure will emit a highly directional beam, with spectral response shown in Fig. 10.

The fabrication methodology described above with reference to the formation of a metamaterial emitter having a single bull's eye structure is expandable using known techniques to generate multiple multiplexed bull's eye structures, such as those shown in Fig. 7. In this case, a reticle is produced in which a concentric circular pattern is repeated in an overlapping manner to form apertures having a multiplexed arrangement, and then the reticle is used to generate a patterned mask including concentric circular resist structures disposed in the multiplexed arrangement, and then using the process described above to form multiple pluralities of overlapping concentric circular metal ridge structures in the multiplexed arrangement.

Although the present invention has been described with respect to certain specific embodiments, it will be clear to those skilled in the art that the inventive features of the present invention are applicable to other embodiments as well, all of which are intended to fall within the scope of the present invention. For example, although metamaterial emitters of the present invention preferably comprise an all-metal construction to maximize operational lifetime, a less robust metamaterial emitter may be constructed using conventional dielectric-plus-metal approaches or all-semiconductor approaches.

## Claims

1. A spectrally-selective metamaterial emitter comprising:

   a solid base substrate having a first surface and an opposing second surface; and
   at least one bull's eye structure disposed on the second surface, each of said at least one said bull's eye structure including a plurality of concentric circular ridge structures separated by intervening circular grooves such that each adjacent pair of said concentric circular ridge structures is separated by a fixed grating period, wherein at least one said bull's eye structure is configured such that, when heat energy is applied to the first surface, radiant energy is emitted from said second surface having a peak emission wavelength that is within 25% of the fixed grating period.

2. The spectrally-selective metamaterial emitter of Claim 1, wherein each adjacent pair of ridge structures is separated by said fixed grating period having a value in the range of less than one nanometer to ten meters.

3. The spectrally-selective metamaterial emitter of Claim 2, wherein each adjacent pair of ridge structures is separated by said fixed grating period in the range of 0.5 microns and 5 microns.

4. The spectrally-selective metamaterial emitter of Claim 3, wherein each adjacent pair of ridge structures is separated by said fixed grating period in the range of 1.0 microns and 2.0 microns.

5. The spectrally-selective metamaterial emitter of Claim 1,
   wherein said at least one bull's eye structure comprises a first bull's eye structure and a second bull's eye structure disposed on the second surface, said first bull's eye structure including a first plurality of concentric circular ridge structures separated by a first fixed grating period, said second bull's eye structure including a second plurality of concentric circular ridge structures separated by a second fixed grating period,
   wherein the second fixed grating period is larger than the first fixed grating period such that first radiant energy emitted from said first bull's eye structure has a first peak emission wavelength that is lower than a second peak emission wavelength of second radiant energy emitted from said second bull's eye structure.

6. The spectrally-selective metamaterial emitter of Claim 1,
wherein said at least one bull's eye structure comprises a first bull's eye structure and a second bull's eye structure, said first first bull's eye structure including a first group of concentric circular ridge structures, and said second bull's eye structure including a second group of concentric circular ridge structures, and
wherein the first and second bull's eye structures are multiplexed such that at least some of the circular ridge structures of the first group intersect at least some of the circular ridge structures of the second group.

7. A spectrally-selective metamaterial emitter comprising:

a box-like enclosure at least partially formed by a peripheral wall including an inward-facing surface that faces an interior cavity of the enclosure, and an outward-facing surface that faces away from the interior cavity; and
at least one bull's eye structure disposed on the outward-facing surface of the peripheral wall, said bull's eye structure including a plurality of concentric circular ridge structures separated by intervening circular grooves such that each adjacent pair of ridge structures is separated by a fixed grating period,
wherein said bull's eye structure is configured such that, when heat energy is supplied into the interior cavity and is sufficient to heat said peripheral wall to a temperature above 1000°K, radiant energy is emitted from said bull's eye structure having a peak emission wavelength that is roughly equal to the fixed grating period.

8. The spectrally-selective metamaterial emitter of Claim 7,
wherein said box-like enclosure comprises an inlet end and outlet end,
wherein said peripheral wall includes first and second peripheral wall portions disposed in an opposing spaced-apart relationship and respectively extending between said inlet and outlet ends of said box-like enclosure such that an inlet opening is defined between respective first end portions of said first and second peripheral wall portions, and an outlet opening is defined between respective second end portions of said first and second peripheral wall portions, and
wherein the at least one bull's eye structure includes a first bull's eye structure disposed on a first outward-facing surface of said first peripheral wall portion, and a second bull's eye structure disposed on a second outward-facing surface of said second peripheral wall portion.

9. A method for fabricating a spectrally-selective metamaterial emitter including at least one bull's eye structure, the method comprising:

utilizing photolithography to generate a patterned mask on a planar surface of a solid substrate comprising a first refractory metal such that the patterned mask includes a plurality of concentric circular resist structures having a fixed grating period in the range of 10 nanometers to 5 microns, wherein each said concentric circular resist structure is separated by an intervening concentric circular slot from an adjacent said concentric circular resist structure;
utilizing the mask to form a plurality of concentric circular ridge structures on the planar surface such that each said circular ridge structure comprises a second refractory metal that is disposed between two adjacent concentric circular resist structures and is spaced from an adjacent said circular ridge structure by said fixed grating period; and
removing said mask from the planar surface, thereby forming a bull's eye structure including said plurality of concentric circular ridge structures separated by intervening circular grooves.

10. The method of Claim 9, wherein utilizing the mask to form a plurality of concentric circular ridge structures comprises one of:

depositing said second refractory metal into the intervening concentric circular slots of said mask, wherein said second refractory metal is either identical to the first refractory metal or a different refractory metal; and
etching said solid metal substrate through said intervening concentric circular slots of said mask, whereby said second refractory metal forming said plurality of concentric circular ridge structures is identical to the first refractory metal.

**FIG. 1**

**FIG. 2**

**FIG. 3(A)**

**FIG. 3(B)**

**FIG. 3(C)**

**FIG. 4**

FIG. 5

FIG. 6(A)

FIG. 6(B)

120D-1/120D-2

FIG. 7

113
111

**FIG. 8(A)**

410    415    410

113
111

**FIG. 8(B)**

422    425    425    $\Lambda$    420
415

**FIG. 8(C)**

429    432    429    431    $\Lambda$    430
113
111

**FIG. 8(D)**

431    431    121    440    121
113
111

**FIG. 8(E)**

100    120
121-2    122    121-1    450    $\Lambda$
113
111

**FIG. 8(F)**

PARC   LEI   2.0KV   X900   10μm   WD 12.7mm

FIG. 9

FIG. 10

Europäisches Patentamt

European Patent Office

Office européen des brevets

**EUROPEAN SEARCH REPORT**

Application Number

EP 15 15 3651

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2010/065071 A2 (UNIV MINNESOTA [US]; NORRIS DAVID J [US]; HAN SANG EON [US]; NAGPAL PR) 10 June 2010 (2010-06-10)<br>* page 11, line 29 - page 20, line 30 *<br>* page 30, line 19 - page 31, line 8 *<br>* figures 2-8 *<br>* page 33, paragraph 1 * | 1-10 | INV.<br>H02S10/30<br>G02B5/00<br>B82Y40/00<br>G02B5/18<br>B82Y20/00 |
| X | David J Norris: "Thermal Plasmonics as a Route to Photovoltaics?",<br>,<br>17 February 2011 (2011-02-17),<br>XP055192648,<br>Retrieved from the Internet:<br>URL:http://cmp.physics.iastate.edu/wavepro/program/presentations/Norris.pdf<br>[retrieved on 2015-06-01]<br>* the whole document * * | 1-10 | |
| X | P. NAGPAL ET AL: "Ultrasmooth Patterned Metals for Plasmonics and Metamaterials", SCIENCE,<br>vol. 325, no. 5940,<br>31 July 2009 (2009-07-31), pages 594-597, XP055006862,<br>ISSN: 0036-8075, DOI: 10.1126/science.1174655 | 9,10 | TECHNICAL FIELDS SEARCHED (IPC)<br><br>H02S<br>G02B<br>B82Y |
| A | * pages 594-595 *<br>* figures 1,2A * | 1-8 | |
| X | S. E. HAN ET AL: "Beaming thermal emission from hot metallic bull's eyes", OPTICS EXPRESS,<br>vol. 18, no. 5,<br>23 February 2010 (2010-02-23), page 4829, XP055030420,<br>ISSN: 1094-4087, DOI: 10.1364/OE.18.004829 | 1-4 | |
| A | * the whole document * * | 5-10 | |

The present search report has been drawn up for all claims

| Place of search | Date of completion of the search | Examiner |
|---|---|---|
| Berlin | 3 June 2015 | Moroz, Alexander |

## ANNEX TO THE EUROPEAN SEARCH REPORT
## ON EUROPEAN PATENT APPLICATION NO.

EP 15 15 3651

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2015

| Patent document cited in search report | Publication date | Patent family member(s) | Publication date |
|---|---|---|---|
| WO 2010065071 A2 | 10-06-2010 | US 2012161600 A1<br>WO 2010065071 A2 | 28-06-2012<br>10-06-2010 |

EPO FORM P0459

For more details about this annex : see Official Journal of the European Patent Office, No. 12/82